# EUROPEAN PATENT SPECIFICATION

(11) **EP 4 495 399 B1**
(45) Date of publication and mention of the grant of the patent: **29.04.2026**
(21) Application number: 24184056.0
(22) Date of filing: 24.06.2024
(51) Int. Cl.: F01P 3/12, B60K 11/02, F01P 7/16, F01P 11/04, F16K 11/085, H01M 10/60, F16K 11/083, F16K 11/22, F16K 27/00, B60K 1/00, F01P 7/14

(54) **COOLING MODULE**
KÜHLMODUL
MODULE DE REFROIDISSEMENT

(30) Priority: 12.07.2023 JP 2023114655
(43) Date of publication of application: 22.01.2025
(73) Proprietor: AISIN CORPORATION, Kariya, Aichi 448-8650 (JP)
(72) Inventor: ISHII, Masato, Kariya, Aichi 448-8650 (JP); YANO, Hideto, Kariya, Aichi 448-8650 (JP)
(74) Representative: Winter, Brandl - Partnerschaft mbB

(56) References cited:
- WO-A1-2023/112738
- CN-U- 218 367 467
- JP-B2- 5 247 277
- JP-B2- 7 178 548
- US-A- 4 254 793

## Description

### TECHNICAL FIELD

This disclosure relates to a cooling module.

### BACKGROUND DISCUSSION

Various techniques for performing thermal management on a thermal management target such as a motor or a battery mounted on a vehicle such as an electric automatic vehicle are disclosed. For example, CN 218367467 U discloses a thermal management water-side integrated assembly that reduces space occupancy, cost, and the like and reduces a risk of water leakage in a pipe line. The thermal management water-side integrated assembly disclosed in CN 218367467 Uincludes a flow path plate on which a plurality of fluid flow paths are formed, and a plurality of thermal management components such as a pump, which are attached to the flow path plate and connected to the fluid flow paths. In addition, a plurality of pipe line external connection interfaces are formed in the flow path plate and are connected to a temperature control loop of a heat management target such as a battery.

In the thermal management water side integrated assembly disclosed in CN 218367467 U, for example, foreign matter contained in a component connected to the pipe line external connection interface may flow through the fluid flow path together with a fluid to cause malfunction of a thermal management component. Further patent document WO 2023/112738 A1 discloses a control valve of a vehicle cooling system, the control valve being provided on the flow path that connects a heat generating unit and a heat dissipation unit of the vehicle. The control valve comprises: a casing; and a rotor. The casing has an inlet and an outlet. The rotor has a circumferential wall in which connection ports are formed. The circumferential wall of the rotor is provided with a diameter-gradually-reduced surface which is gradually reduced in outer diameter from one end side to the other end side in the axial direction and in which the connection ports are formed. A rotor storage of the casing is provided with a rotor guide surface which is gradually increased, in the radially-inward protruding amount, from one end side to the other end side in the axial direction and which abuts, at the radially-inward end surface thereof, against the diameter-gradually-reduced surface of the circumferential wall so as to freely slide. The outlet is disposed on a part of the rotor guide surface so as to face the circumferential wall of the rotor.

A need thus exists for a cooling module that restricts the flow of foreign matter in a fluid flow path.

### SUMMARY

Said object is solved by a cooling module with the features of claim 1. According to an aspect of this disclosure, a cooling module includes a manifold to which a valve configured to control flow of a fluid is attached and in which a fluid flow path configured to allow the fluid to flow therethrough is formed. The manifold includes a foreign matter reservoir having a flow path cross-sectional area larger than a flow path cross-sectional area of the fluid flow path and storing a foreign matter flowing through the fluid flow path. The foreign matter reservoir is connected to at least one of an inflow port configured to allow the fluid to flow therethrough into the valve and an outflow port configured to allow the fluid to flow therethrough out of the valve.

According to such a characteristic configuration, the manifold includes the foreign matter reservoir that stores the foreign matter flowing through the fluid flow path, and therefore, the flow of the foreign matter in the fluid flow path can be prevented. The foreign matter reservoir is connected to at least one of the inflow port of the valve and the outflow port of the valve, and therefore, the inflow of the foreign matter into the valve can also be prevented.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a diagram illustrating a part of a cooling circuit of a cooling system according to an embodiment;
FIG. 2 is an exploded perspective view illustrating a configuration of a cooling module according to the embodiment;
FIG. 3 is a cross-sectional view illustrating a configuration of a valve and a vicinity thereof illustrated in FIG. 2;
FIG. 4 is a cross-sectional view illustrating a configuration of the valve in a posture different from that of FIG. 3 and a vicinity thereof;
FIG. 5 is a cross-sectional view taken along a line V-V illustrated in FIG. 3; and
FIG. 6 is a cross-sectional view taken along a line VI-VI illustrated in FIG. 4.

### DETAILED DESCRIPTION

Hereinafter, embodiments of a cooling module according to this disclosure will be described with reference to the drawings. However, this disclosure is not limited to the following embodiments, and various modifications can be made without departing from the scope of the invention as defined by the appended claims.

### Cooling Module

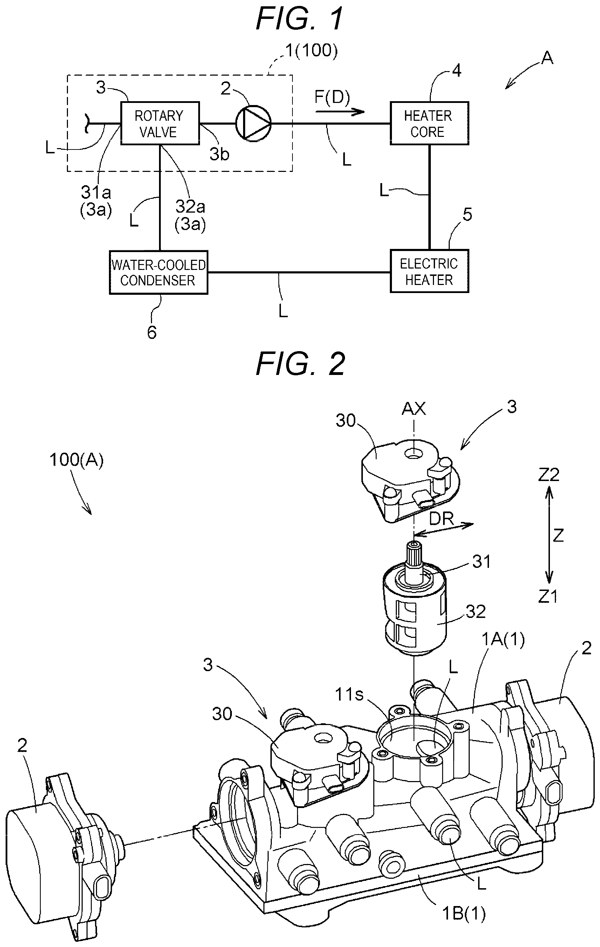

First, a cooling system A including a cooling module 100 will be described with reference to FIG. 1. FIG. 1 is a diagram illustrating a part of a cooling circuit of the cooling system A.

The cooling module 100 is mounted on an electric vehicle that travels by electric power. Examples of the electric vehicle include a hybrid electric vehicle (HEV), a plug-in hybrid electric vehicle (PHEV), a battery electric vehicle (BEV), and a fuel cell electric vehicle (FCEV).

The cooling system A cools (performs temperature management of) a cooling target device (temperature management target device) (not illustrated) mounted on an electric vehicle. The cooling target device includes an inverter/motor as a traveling drive source that operates by being supplied with power, a battery that stores electric power, and the like. The electric power stored in the battery is supplied to the inverter/motor.

As illustrated in FIG. 1, the cooling system A includes a fluid flow path L through which a fluid F for cooling a cooling target device flows. The fluid F is a cooling fluid such as a long life coolant (LLC). In this case, the fluid F is not limited to a cooling fluid such as a long life coolant (LLC), and may be a refrigerant such as an insulating oil, for example, a paraffin-based oil, a hydrofluorocarbon (HFC), and a hydrofluoroolefin (HFO).

The cooling system A further includes a manifold 1, a pump 2, a valve 3, a heater core 4, an electric heater 5, and a water-cooled condenser 6. The manifold 1, the pump 2, the valve 3, the heater core 4, the electric heater 5, and the water-cooled condenser 6 are connected to the cooling target device via the fluid flow path L.

The pump 2 pressure-feeds the fluid F. The valve 3 controls the flow of the fluid F. The heater core 4 heats the air with the fluid F to increase the temperature inside a vehicle interior. The electric heater 5 heats the fluid F in the case where the temperature of the fluid F is lower than a preset temperature. The water-cooled condenser 6 cools the fluid F in the case where the temperature of the fluid F is higher than the preset temperature. The cooling target device is cooled by the fluid F flowing through the fluid flow path L. Hereinafter, a direction in which the fluid F flows through the fluid flow path L is referred to as a "flow direction D".

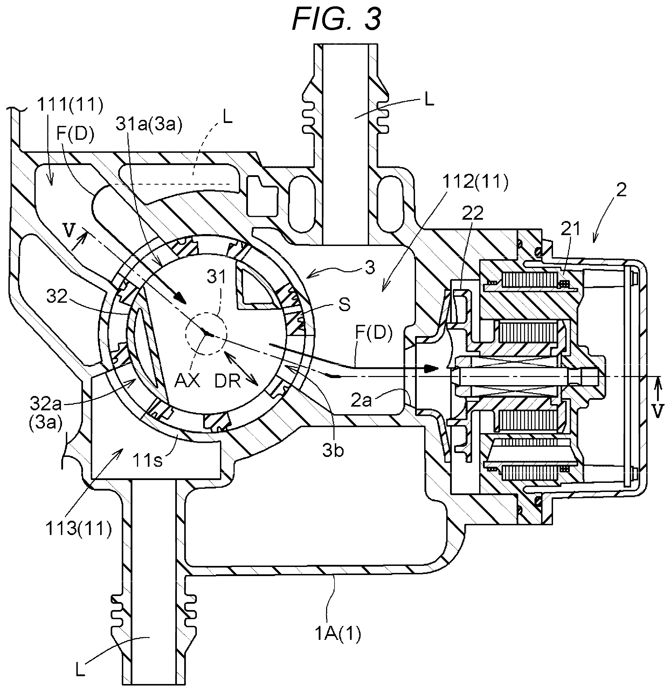

Next, the cooling module 100 forming a part of the cooling system A will be described with reference to FIGS. 2 and 3. FIG. 2 is an exploded perspective view illustrating a configuration of the cooling module 100. FIG. 3 is a cross-sectional view illustrating a configuration of one of two valves 3 integrated with the cooling module 100 (a three-way valve on the right side when FIG. 2 is viewed) and a vicinity thereof.

As illustrated in FIG. 2, the cooling module 100 is formed by integrating the manifold 1, the pumps 2, and the valves 3. In the present embodiment, the cooling system A includes two pumps 2, and the two pumps 2 are respectively attached to end portions of the manifold 1 in a longitudinal direction. Note that the two pumps 2 have substantially the same configuration, only except that the two pumps 2 are attached to the manifold 1 at different positions. In the present embodiment, the cooling module 100 includes two valves 3, and the two valves 3 are respectively attached (rotatably accommodated) in valve housings 11s formed in a central portion of the manifold 1. Each of the two valves 3 is a multiway valve such as a three-way valve or a four-way valve, and a valve corresponding to the fluid flow path L through which the fluid F flows is used. Hereinafter, one valve 3 of the two valves 3 (the three-way valve on the right side in FIG. 2) will be described as an example.

### Manifold

The manifold 1 includes a first housing 1A and a second housing 1B. The manifold 1 is formed by joining the first housing 1A and the second housing 1B. The first housing 1A and the second housing 1B are joined by, for example, welding using a resin as a material.

The manifold 1 has a box shape (approximately rectangular parallelepiped shape) and includes the fluid flow path L. The fluid flow path L is formed inside the manifold 1 by grooves, holes, and the like formed in at least one of the first housing 1A and the second housing 1B. In the manifold 1 according to the present embodiment, auxiliary devices such as the pumps 2 and the valves 3 are fixed to the first housing 1A, and the second housing 1B includes only the fluid flow path L to which the auxiliary devices are not connected and a reservoir space 11U described below.

### Pump

As illustrated in FIG. 3, the pump 2 is an electric water pump. The pump 2 includes an electric motor 21 and an impeller 22. The electric motor 21 drives and rotates the impeller 22 by being supplied with electric power.

The pump 2 includes a suction port 2a for sucking the fluid F and a discharge port (not illustrated) for discharging the fluid F. The fluid F is sucked into the pump 2 through the suction port 2a, and is discharged to an outside (fluid flow path L) of the pump 2 via the discharge port by a rotational force (centrifugal force) of the impeller 22.

### Valve

As illustrated in FIG. 2, the valve 3 is a rotary valve. The valve 3 includes a drive source 30, a rotary shaft 31, and a valve body 32. The drive source 30 is an actuator or the like, and generates power by being supplied with electric power. The rotary shaft 31 receives power from the drive source 30 and rotates about an axis AX. The valve body 32 rotates about the rotary shaft 31. Hereinafter, a direction along the axis AX of the rotation shaft 31 is referred to as a "Z direction", a side on which the valve body 32 is disposed with respect to the drive source 30 in the Z direction is referred to as a "first axis side Z1", and an opposite side thereof is referred to as a "second axis side Z2". In the present embodiment, the cooling module 100 is used with the first axis side Z1 as a "lower side in a vertical direction" and the second axis side Z2 as an "upper side in the vertical direction".

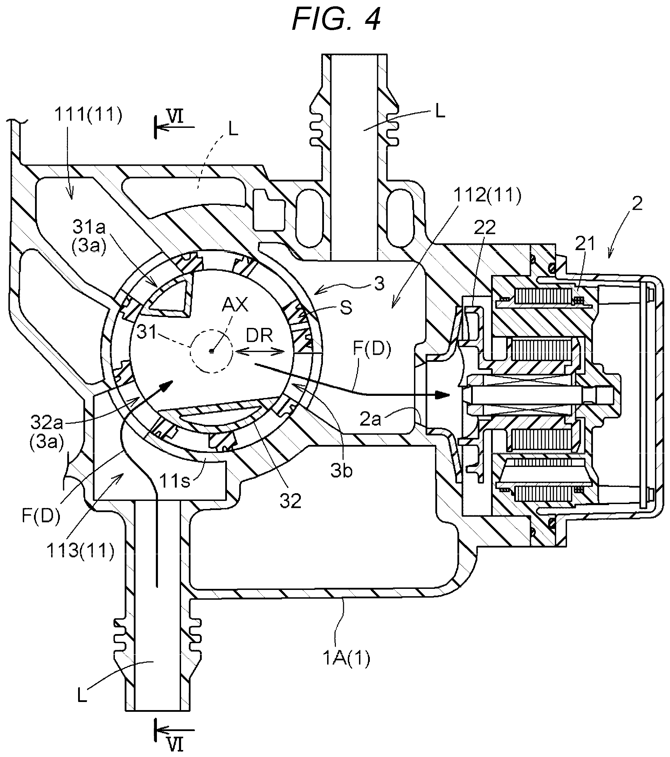

As shown in FIGS. 3 and 4, the valve 3 controls the flow of the fluid F by rotating the valve body 32 together with the rotation shaft 31. FIG. 4 is a cross-sectional view illustrating a configuration of the valve 3 in a posture different from that of FIG. 3 and a vicinity thereof. Hereinafter, the posture of the valve 3 illustrated in FIG. 3 is referred to as a "first posture", and the posture of the valve 3 illustrated in FIG. 4 is referred to as a "second posture".

The valve 3 includes an inflow port 3a through which the fluid F flows in and an outflow port 3b from which the fluid F flows out. The inflow port 3a includes a first inflow port 31a through which the fluid F flows into the valve 3 in the first posture illustrated in FIG. 3, and a second inflow port 32a through which the fluid F flows into the valve 3 in the second posture illustrated in FIG. 4. In the valve 3 in the first posture and the second posture, the fluid F flows out of the valve 3 through the outflow port 3b.

The valve 3 further includes a seal member S. The seal member S is disposed outside the valve body 32 in a radial direction DR. The seal member S prevents leakage of the fluid F from the inflow port 3a and the outflow port 3b.

### Foreign Matter Reservoir

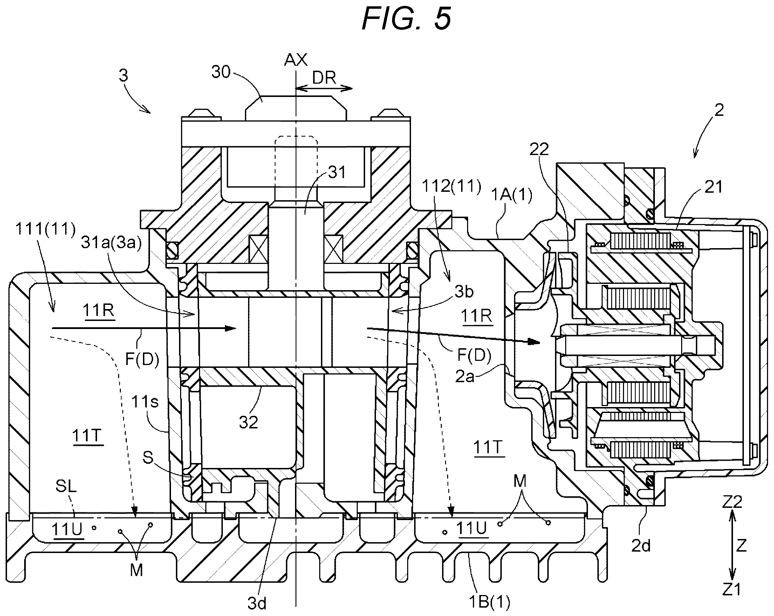

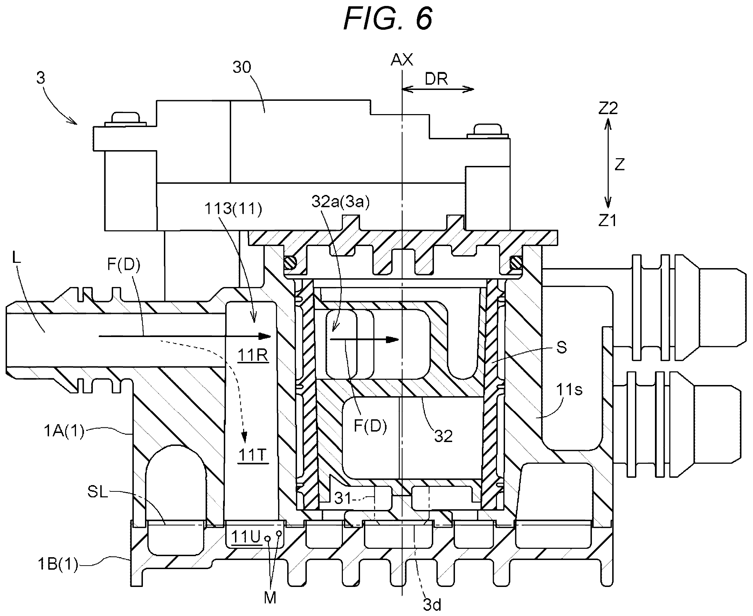

Next, a configuration of the manifold 1 will be described in detail with reference to FIGS. 3 to 6. FIG. 5 is a cross-sectional view taken along a line V-V illustrated in FIG. 3, and FIG. 6 is a cross-sectional view taken along a line VI-VI illustrated in FIG. 4.

As illustrated in FIGS. 3 to 6, the manifold 1 includes a foreign matter reservoir 11 that stores foreign matter M such as casting sand, dust, and dirt. The foreign matter M is contained, for example, inside the auxiliary devices. In particular, the casting sand may be generated in the process of producing the auxiliary devices and may remain inside the auxiliary devices. When the auxiliary devices including the foreign matter M are connected to the fluid flow path L and the fluid F flows through the auxiliary devices, the foreign matter M flows through the fluid flow path L. The auxiliary devices include the manifold 1, the pump 2, the valve 3, the heater core 4, the electric heater 5, and the water-cooled condenser 6 described with reference to FIG. 1.

As shown in FIGS. 5 and 6, the foreign matter reservoir 11 is formed between the first housing 1A and the second housing 1B by joining the first housing 1A and the second housing 1B. The foreign matter reservoir 11 is a space formed across the first housing 1A and the second housing 1B. That is, the foreign matter reservoir 11 is a space extending along the Z direction (vertical direction). The foreign matter reservoir 11 is a space having a flow path cross-sectional area larger than the flow path cross-sectional area of the fluid flow path L (see FIGS. 4 and 6). The flow path cross-sectional area is an area of a cross section of the fluid flow path, which is obtained by being cut along a direction perpendicular to a direction (flow direction D) in which the main flow of the fluid F flows.

As described above, the foreign matter reservoir 11 is a space having a flow path cross-sectional area larger than the flow path cross-sectional area of the fluid flow path L. In the present embodiment, the foreign matter M has a larger specific gravity than the fluid F, and therefore, when the foreign matter M flows into the foreign matter reservoir 11 together with the fluid F flowing through the fluid flow path L, the foreign matter M is guided (immersed) to the first axis side Z1 (lower side in the vertical direction) due to a difference in specific gravity (own weight).

The foreign matter M guided to the first axis side Z1 (the lower side in the vertical direction) in the foreign matter reservoir 11 stays in the foreign matter reservoir 11. Accordingly, the flow of the foreign matter M in the fluid flow path L can be prevented.

The foreign matter reservoir 11 includes a flow portion 11R through which the main flow of the fluid F flows and a stagnation portion 11T in which the fluid F stagnates. A split flow different from the main flow of the fluid F (the fluid F having a flow velocity lower than that in the flow portion (11R)) may flow in the stagnation portion 11T.

The flow portion 11R is a space between a lower end of each of the inflow port 3a of the valve 3 (also see FIG. 6), the outflow port 3b of the valve 3, and the suction port 2a of the pump 2 and the second axis side Z2 (upper side in the vertical direction) with respect to the lower ends in the radial direction DR (direction perpendicular to the Z direction). The flow portion 11R includes a portion facing any one of the inflow port 3a of the valve 3, the outflow port 3b of the valve 3, and the suction port 2a of the pump 2.

The stagnation portion 11T is a space disposed on the first axis side Z1 (lower side in the vertical direction) with respect to the flow portion 11R. That is, in the present embodiment, the stagnation portion 11T is a space on the first axis side Z1 (lower side in the vertical direction) with respect to each of the inflow port 3a (also see FIG. 6) of the valve 3, the outflow port 3b of the valve 3, and the suction port 2a of the pump 2.

In the present embodiment, the stagnation portion 11T includes the reservoir space 11U. The reservoir space 11U is disposed on the first axis side Z1 (lower side in the vertical direction) with respect to the valve 3. Specifically, the reservoir space 11U is a space on the first axis side Z1 (lower side in the vertical direction) with respect to a standard line SL along a lower end 3d of the valve 3. In the present embodiment, the reservoir space 11U is formed in the second housing 1B.

In the present embodiment, as shown in FIGS. 3 and 4, the foreign matter reservoir 11 includes a first reservoir 111, a second reservoir 112, and a third reservoir 113. The first reservoir 111, the second reservoir 112, and the third reservoir 113 are disposed around the valve 3. Specifically, the first reservoir 111 is disposed adjacent to the first inflow port 31a of the valve 3, the second reservoir 112 is disposed adjacent to the outflow port 3b of the valve 3, and the third reservoir 113 is disposed adjacent to the second inflow port 32a of the valve 3. The second reservoir 112 is also disposed adjacent to the suction port 2a of the pump 2. That is, the second reservoir 112 is disposed between the valve 3 and the pump 2.

As shown in FIG. 3, the first reservoir 111 is disposed upstream of the first inflow port 31a of the valve 3 in the first posture in the flow direction D, and is connected (directly connected) to the first inflow port 31a. The flow portion 11R of the first reservoir 111 described with reference to FIG. 5 communicates with the first inflow port 31a of the valve 3 in the first posture (faces the first inflow port 31a in the radial direction DR). Therefore, the fluid F flows through the flow portion 11R of the first reservoir 111 and flows into the valve 3 via the first inflow port 31a. The foreign matter M flowing into the first reservoir 111 together with the fluid F is guided to the reservoir space 11U of the first reservoir 111 and stays in the reservoir space 11U.

The second reservoir 112 is disposed downstream of the outflow port 3b of the valve 3 in the first posture (see FIG. 3) and the second posture (see FIG. 4) in the flow direction D, and is connected (directly connected) to the outflow port 3b. The flow portion 11R of the second reservoir 112 described with reference to FIG. 5 communicates with the outflow port 3b of the valve 3 in the first posture and the second posture (faces the outflow port 3b in the radial direction DR).

The second reservoir 112 is disposed upstream of the suction port 2a of the pump 2 in the flow direction D, and is connected (directly connected) to the suction port 2a. That is, the flow portion 11R of the second reservoir 112 communicates with the suction port 2a (faces the suction port 2a in the radial direction DR). Therefore, the fluid F flows from the valve 3 into the second reservoir 112 through the outflow port 3b, flows through the flow portion 11R of the second reservoir 112, and is sucked into the pump 2 via the suction port 2a. The foreign matter M flowing into the second reservoir 112 together with the fluid F is guided to the reservoir space 11U of the second reservoir 112 and stays in the reservoir space 11U.

As illustrated in FIG. 4, the third reservoir 113 is disposed upstream of the second inflow port 32a of the valve 3 in the second posture in the flow direction D, and is connected (directly connected) to the second inflow port 32a. The flow portion 11R of the third reservoir 113 described with reference to FIG. 6 communicates with the second inflow port 32a of the valve 3 in the second posture (faces the second inflow port 32a in the radial direction DR). Therefore, the fluid F flows through the flow portion 11R of the third reservoir 113 and flows into the valve 3 via the second inflow port 32a. The foreign matter M flowing into the third reservoir 113 together with the fluid F is guided to the reservoir space 11U of the third reservoir 113 and stays in the reservoir space 11U.

As described above, the first reservoir 111 and the third reservoir 113 are disposed upstream of the valve 3 in the flow direction D. Therefore, the foreign matter M can be guided (caught) to the reservoir spaces 11U before flowing into the valve 3. Accordingly, the inflow of the foreign matter M into the valve 3 can be prevented. The second reservoir 112 is disposed downstream of the valve 3 in the flow direction D. Therefore, the foreign matter M guided to the reservoir space 11U of the second reservoir 112 can be prevented from flowing into the valve 3 with the backflow of the fluid F or against the flow of the fluid F. The inflow of the foreign matter M into the valve 3 can be prevented, and therefore, for example, the malfunction of the valve 3 caused by the foreign matter M interposed between the seal member S and the valve body 32 can be prevented. In addition, damage to the valve body 32, the seal member S, and the like can be prevented, and shortening of the service life of the valve 3 can also be prevented.

The second reservoir 112 is disposed upstream of the pump 2 in the flow direction D. Therefore, the foreign matter M can be guided (caught) to the reservoir space 11U before flowing into the pump 2. Accordingly, the inflow of the foreign matter M into the pump 2 can be prevented. As a result, for example, the malfunction of the pump 2 caused by the foreign matter M interposed between the electric motor 21 and the impeller 22 can be prevented. In addition, damage to the electric motor 21, the impeller 22, and the like can also be prevented, and shortening of the service life of the pump 2 can also be prevented.

As described with reference to FIGS. 5 and 6, the reservoir space 11U is disposed on the first axis side Z1 (the lower side in the vertical direction) with respect to the valve 3. Accordingly, the foreign matter M guided to the reservoir space 11U is more reliably prevented from flowing out of the foreign matter reservoir 11 and flowing into the valve 3. In the present embodiment, the reservoir space 11U is disposed on the first axis side Z1 (lower side in the vertical direction) with respect to a lower end 2d of the pump 2. Therefore, the foreign matter M guided to the reservoir space 11U is prevented from flowing out of the foreign matter reservoir 11 and flowing into the pump 2.

### Overview of Above-described Embodiment

In the above-described embodiment, the following configurations are considered.
(1) A cooling module 100 includes a manifold 1 to which a valve 3 configured to control flow of a fluid F is attached and in which a fluid flow path L configured to allow the fluid F to flow therethrough is formed. The manifold 1 includes a foreign matter reservoir 11 having a flow path cross-sectional area larger than a flow path cross-sectional area of the fluid flow path L and storing a foreign matter M flowing through the fluid flow path L. The foreign matter reservoir 11 is connected to at least one of an inflow port 3a configured to allow the fluid F to flow therethrough into the valve 3 and an outflow port 3b configured to allow the fluid F to flow out of the valve 3.
   According to this configuration, the manifold 1 includes the foreign matter reservoir 11 that stores the foreign matter M flowing through the fluid flow path L, and therefore, the flow of the foreign matter M in the fluid flow path L can be prevented. The foreign matter reservoir 11 is connected to at least one of the inflow port 3a of the valve 3 and the outflow port 3b of the valve 3, and therefore, the foreign matter M is prevented from flowing into the valve 3.
(2) In the cooling module 100 according to (1), it is preferable that the foreign matter reservoir 11 is connected to a suction port 2a through which the fluid F is sucked into a pump 2 configured to pressure-feed the fluid F.
   According to this configuration, the foreign matter reservoir 11 is connected to the suction port 2a of the pump 2. In other words, the foreign matter reservoir 11 is disposed upstream of the pump 2 in the flow direction D of the fluid F. Therefore, the inflow of the foreign matter M into the pump 2 is prevented.
(3) In the cooling module 100 according to (1) or (2), it is preferable that the manifold 1 includes a first housing 1A and a second housing 1B joined to the first housing 1A, and the foreign matter reservoir 11 is formed between the first housing 1A and the second housing 1B.
   According to this configuration, the foreign matter reservoir 11 is formed between the first housing 1A and the second housing 1B which are separate components. Therefore, the foreign matter reservoir 11 can be easily provided.
(4) In the cooling module 100 according to (3), it is preferable that the foreign matter reservoir 11 has a reservoir space 11U on a lower side in a vertical direction with respect to the valve 3.

According to this configuration, the foreign matter reservoir 11 has the reservoir space 11U on the lower side in the vertical direction with respect to the valve 3, and therefore, the foreign matter M can be more reliably prevented from flowing into the valve 3.

### Other Embodiments

Next, other embodiments of the cooling module will be described.
(a) The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive.
(b) The foreign matter reservoir 11 may also be disposed at a position other than the periphery of the valve 3 so as to efficiently catch the foreign matter M flowing through the fluid flow path L.
(c) In the above-described embodiment, the foreign matter reservoir 11 includes the first reservoir 111, the second reservoir 112, and the third reservoir 113, the first reservoir 111 and the third reservoir 113 are connected to the inflow port 3a of the valve 3, and the second reservoir 112 is connected to the outflow port 3b of the valve 3. However, the foreign matter reservoir 11 may be connected to at least one of the inflow port 3a and the outflow port 3b of the valve 3. That is, the foreign matter reservoir 11 may include, for example, only at least one of the first reservoir 111 and the third reservoir 113 that are connected to the inflow port 3a, or only the second reservoir 112 connected to the outflow port 3b.
(d) The second reservoir 112 is connected to the suction port 2a of the pump 2 in the above-described embodiment, and the second reservoir 112 may not be connected to the suction port 2a of the pump 2. The second reservoir 112 may be connected to a discharge port of the pump 2.
(e) In the above-described embodiment, the first reservoir 111 and the third reservoir 113 are directly connected to the inflow port 3a of the valve 3, and the second reservoir 112 is directly connected to the outflow port 3b of the valve 3 and the suction port 2a of the pump 2. Note that "direct connection" refers to a configuration in which connection is performed without a gap. Specifically, a gap is not provided between the first reservoir 111 and the first inflow port 31a of the valve 3, and the first reservoir 111 and the first inflow port 31a of the valve 3 are connected with each other. The same applies to the space between the third reservoir 113 and the second inflow port 32a of the valve 3, the space between the second reservoir 112 and the outflow port 3b, and the space between the second reservoir 112 and the suction port 2a of the pump 2. In this case, for example, the fluid flow path L may be interposed between at least one of the first reservoir 111 and the third reservoir 113 and the inflow port 3a of the valve 3. Similarly, for example, the fluid flow path L may be interposed between the second reservoir 112 and at least one of the outflow port 3b of the valve 3 and the suction port 2a of the pump 2.
(f) The reservoir space 11U of the foreign matter reservoir 11 may be omitted.
(g) The cooling system A includes devices (for example, a radiator, a chiller, a DC-DC converter, and a charger) other than the manifold 1, the pump 2, the valve 3, the heater core 4, the electric heater 5, and the water-cooled condenser 6, and these devices may be connected to the fluid flow path L.

### Industrial Applicability

The technique according to the present disclosure can be used for a cooling module.

## Claims

1. Cooling module (100) comprising:
a manifold (1) to which a valve (3) configured to control flow of a fluid (F) is attached and in which a fluid flow path (L) configured to allow the fluid to flow therethrough is formed, wherein
the manifold (1) includes a foreign matter reservoir (11) having a flow path cross-sectional area larger than a flow path cross-sectional area of the fluid flow path (L) and storing a foreign matter (M) flowing through the fluid flow path (L), and
the foreign matter reservoir (11) is connected to at least one of an inflow port (3a) configured to allow the fluid to flow therethrough into the valve (3) and an outflow port (3b) configured to allow the fluid to flow therethrough out of the valve (3),
**characterized in that**
the manifold (1) includes a first housing (1A) and a second housing (1B) joined to the first housing (1A), and
the foreign matter reservoir (11) is formed between the first housing (1A) and the second housing (1B).

2. Cooling module (100) according to claim 1, wherein
the foreign matter reservoir (11) is connected to a suction port (2a) through which the fluid is sucked into a pump (2) configured to pressure-feed the fluid.

3. Cooling module (100) according to claim 1 or 2, wherein
the foreign matter reservoir (11) has a reservoir space (11U) on a lower side (Z1) in a vertical direction (Z) with respect to the valve (3).

## Patentansprüche

1. Kühlmodul (100), umfassend:
einen Verteiler (1), an dem ein Ventil (3) angebracht ist, das konfiguriert ist, um die Strömung eines Fluids (F) zu steuern, und in dem ein Fluidströmungsweg (L) ausgebildet ist, der konfiguriert ist, um dem Fluid zu ermöglichen, dort hindurch zu strömen, wobei
der Verteiler (1) einen Fremdstoffbehälter (11) beinhaltet, der eine Strömungswegquerschnittsfläche aufweist, die größer als eine Strömungswegquerschnittsfläche des Fluidströmungswegs (L) ist, und einen Fremdstoff (M) speichert, der durch den Fluidströmungsweg (L) strömt, und
der Fremdstoffbehälter (11) mit mindestens einem von einem Einströmanschluss (3a), der konfiguriert ist, um dem Fluid zu ermöglichen, dort hindurch in das Ventil (3) zu strömen, und einem Ausströmanschluss (3b), der konfiguriert ist, um dem Fluid zu ermöglichen, dort hindurch aus dem Ventil (3) zu strömen, verbunden ist,
**dadurch gekennzeichnet, dass**
der Verteiler (1) ein erstes Gehäuse (1A) und ein zweites Gehäuse (1B) beinhaltet, das mit dem ersten Gehäuse (1A) verbunden ist, und
der Fremdstoffbehälter (11) zwischen dem ersten Gehäuse (1A) und dem zweiten Gehäuse (1B) ausgebildet ist.

2. Kühlmodul (100) nach Anspruch 1, wobei
der Fremdstoffbehälter (11) mit einem Ansauganschluss (2a) verbunden ist, durch den das Fluid in eine Pumpe (2) gesaugt wird, die konfiguriert ist, um das Fluid unter Druck zuzuführen.

3. Kühlmodul (100) nach Anspruch 1 oder 2, wobei
der Fremdstoffbehälter (11) einen Behälterraum (11U) auf einer unteren Seite (Z1) in einer vertikalen Richtung (Z) in Bezug auf das Ventil (3) aufweist.

## Revendications

1. Module de refroidissement (100) comprenant :
un collecteur (1) auquel est fixée une vanne (3) configurée pour commander l'écoulement d'un fluide (F) et dans lequel est formé un trajet d'écoulement de fluide (L) configuré pour permettre au fluide de s'y écouler, dans lequel
le collecteur (1) inclut un réservoir de matières étrangères (11) présentant une section transversale de trajet d'écoulement plus grande que celle du trajet d'écoulement de fluide (L) et stockant une matière étrangère (M) s'écoulant à travers le trajet d'écoulement de fluide (L), et
le réservoir de matières étrangères (11) est relié à au moins un orifice d'entrée (3a) configuré pour permettre au fluide de s'écouler à travers celui-ci dans la vanne (3) et à un orifice de sortie (3b) configuré pour permettre au fluide de s'écouler à travers celui-ci hors de la vanne (3).
**caractérisé en ce que**
le collecteur (1) inclut un premier boîtier (1A) et un second boîtier (1B) relié au premier boîtier (1A), et
le réservoir de matières étrangères (11) est formé entre le premier boîtier (1A) et le second boîtier (1B).

2. Module de refroidissement (100) selon la revendication 1, dans lequel
le réservoir de matières étrangères (11) est relié à un orifice d'aspiration (2a) par lequel le fluide est aspiré dans une pompe (2) configurée pour alimenter le fluide sous pression.

3. Module de refroidissement (100) selon la revendication 1 ou 2, dans lequel
le réservoir de matières étrangères (11) présente un espace de réservoir (11U) sur un côté inférieur (Z1) dans une direction verticale (Z) par rapport à la vanne (3).
